# EUROPÄISCHE PATENTANMELDUNG

(11) **EP 2 116 857 A1**
(43) Veröffentlichungstag der Anmeldung: **11.11.2009**
(21) Anmeldenummer: 08155695.3
(22) Anmeldetag: 06.05.2008
(51) Int. Cl.: G01R 31/34, H02M 7/5387, H02P 7/29

(54) **Verfahren und Einrichtung zum Erfassen einer Strompolarität innerhalb eines getakteten Brückenzweiges**

(71) Anmelder: ebm-papst Mulfingen GmbH & Co. KG, 74673 Mulfingen (DE)
(72) Erfinder: Kilian, Thomas, 74238, Krautheim (DE); Rupp, Thomas, 97959, Assamstadt (DE)
(74) Vertreter: Patentanwälte Dr. Solf & Zapf

(57) **Zusammenfassung**

Die vorliegende Erfindung betrifft ein Verfahren zum Erfassen einer Strompolarität eines durch eine induktive Last (U, V, W; L) fließenden Stromes (I_{Br}), wobei die Last (U, V, W; L) an einem Brückenzweig (B) einer aus Transistoren (THS, TLS) bestehenden Brücken-Endstufe (4) liegt und die Endstufe (4) über eine Steuereinheit (6) zumindest zeitweise getaktet angesteuert wird. Dabei wird die Strompolarität indirekt durch eine Auswertung des zeitlichen Verlaufs von Schaltflanken einer am Brückenzweig (B) abgegriffenen Brückenspannung (U_{Br}) während einer Totzeit im ausgeschalteten Zustand der dem Brückenzweig (B) zugeordneten Transistoren (THS, TLS) bestimmt. Eine Einrichtung zur Durchführung des Verfahrens umfasst eine Auswerteeinheit (8) für eine am Brückenzweig (B) abgegriffene Brückenspannung (U_{Br}) auf ihren zeitlichen Verlauf während einer Totzeit im ausgeschalteten Zustand der dem Brückenzweig (B) zugeordneten Transistoren (THS, TLS).

## Beschreibung

Die vorliegende Erfindung betrifft ein Verfahren zum Erfassen einer Strompolarität eines durch eine induktive Last fließenden Stromes, wobei die Last an einem Brückenzweig einer aus Transistoren bestehenden Brücken-Endstufe liegt und die Endstufe über eine Steuereinheit zumindest zeitweise getaktet angesteuert wird.

Außerdem betrifft die Erfindung auch eine Einrichtung zur Durchführung des genannten Verfahrens.

In der Elektrotechnik gibt es zahlreiche Anwendungen, bei denen eine Polarität bzw. Flussrichtung eines Stromes erfasst werden muss. Dies ist vor allem dann der Fall, wenn die Phasenlage eines Wechselstromes ermittelt werden soll, wozu mindestens ein Strom-Nulldurchgang anhand eines Polaritätswechsels bestimmt wird.

Beispielsweise ist dies der Fall bei getakteten Elektromotor-Steuerungen, insbesondere in Verbindung mit einer Sinusmodulation der von der Endstufe ausgegebenen Motorspannungen, um die im Motor bzw. dessen Wicklungen induzierte Polradspannung und den in den Motorwicklungen fließenden Strom auf Phasengleichheit regeln zu können und so den Motorwirkungsgrad zu optimieren. Der Wirkungsgrad ist optimal, wenn Motorstrom und induzierte Polradspannung in Phase sind. Durch den Einfluss der Motor-Induktivität (Wicklungen wirken als induktive Last) entsteht jedoch eine von der Motor-Belastung und der Motor-Drehzahl abhängige Phasenverschiebung zwischen Motorstrom und Polradspannung. Ist diese Phasenverschiebung bekannt, kann die von der Endstufe ausgegebene Motorspannung entsprechend phasenverschoben erfolgen, um damit die Phasenverschiebung zwischen Motorstrom und Polradspannung zu kompensieren.

Es ist bekannt, eine Strompolarität durch Auswertung eines Spannungsabfalls an einem Messwiderstand (so genannter Shunt) zu ermitteln. Im Falle einer aus MOSFETs bestehenden Endstufe kann auch der Spannungsabfall über dem so genannten Bahn-Widerstand eines MOSFETs ermittelt werden. Im Falle von IGBTs kann auch deren Flussspannung ausgewertet werden. Dabei wird die Spannung synchron zur Endstufentaktung (PWM) mittels Komparator oder ähnlichem ausgewertet, und zwar genau zu dem Zeitpunkt, zu dem der entsprechende Transistor angesteuert ist. Der nur endlich kleine Bahn-Widerstand des Transistors bzw. der Shunt verursacht einen Spannungsabfall, der gegebenenfalls verstärkt werden muss, um ausgewertet werden zu können. Messtechnisch vorteilhaft ist aber ein möglichst großes Nutzsignal (Spannungsabfall), aus Verlustgründen ist jedoch ein möglichst kleiner Spannungsabfall anstrebenswert. So muss in der Praxis stets ein nachteiliger Kompromiss zwischen ausreichender Signalqualität und akzeptablen Verlusten gefunden werden.

Der vorliegenden Erfindung liegt die Aufgabe zu Grunde, ein Verfahren der genannten Art anzugeben, mit dem bei hoher Signalqualität Verluste vermieden oder zumindest reduziert und auch Bauteile eingespart werden können. Ferner soll auch eine konstruktiv und schaltungstechnisch einfache und hinsichtlich des Bauteilaufwandes wirtschaftliche Einrichtung zur Durchführung des Verfahrens geschaffen werden.

Erfindungsgemäß wird dies dadurch erreicht, dass die Strompolarität indirekt durch eine Auswertung des zeitlichen Verlaufs von Schaltflanken einer am Brückenzweig abgegriffenen Brückenspannung während einer Totzeit im ausgeschalteten Zustand der dem Brückenzweig zugeordneten Transistoren bestimmt wird.

Der Erfindung liegt die Erkenntnis zu Grunde, dass der zeitliche Verlauf der Brückenspannung während der Schalt-Totzeit bei unterschiedlichen Stromrichtungen ebenfalls eindeutig unterschiedlich ist.

Die Transistoren der Brücken-Endstufe sind als MOSFETs oder als IGBTs ausgebildet und enthalten daher bauartbedingt parallel zur Transistor-Schaltstrecke (Drain-Source) jeweils eine Freilaufdiode und eine so genannte parasitäre Kapazität, woraus bei unterschiedlichen Stromrichtungen eindeutig unterschiedliche Schaltflanken der Brückenspannung während der Schalt-Totzeiten der getakteten Brücken-Transistoren resultieren. Dies wird im Folgenden noch genauer erläutert werden.

Die erfindungsgemäße Einrichtung zur Durchführung des erfindungsgemäßen Verfahrens weist demzufolge eine Auswerteeinheit auf, die dazu konzipiert ist, die am Brückenzweig abgegriffene Brückenspannung auf ihren zeitlichen Verlauf während einer Totzeit im ausgeschalteten Zustand der dem Brückenzweig zugeordneten Transistoren auszuwerten. Auch dazu wird im Folgenden noch ein konkretes Ausführungsbeispiel genauer beschrieben werden.

Im Übrigen sind vorteilhafte Ausgestaltungen der Erfindung in den jeweils abhängigen Ansprüchen enthalten.

Anhand der Zeichnung soll im Folgenden die Erfindung beispielhaft genauer erläutert werden, und zwar anhand einer bevorzugten Anwendung für eine Steuerung eines Elektromotors über eine getaktete Brücken-Endstufe. Es zeigen:
- Fig. 1: ein vereinfachtes, schematisches Blockschaltbild einer solchen getakteten Motor-Steuerung,
- Fig. 2: ein weiteres Blockschaltbild ähnlich Fig. 1 mit zusätzlichen Details im Bereich einer Auswerteeinheit zur Stromnulldurchgangserfassung,
- Fig. 3: diverse Signal-Diagramme der Motor-Steuerung,
- Fig.4a-4d: jeweils einen Ausschnitt der Brücken-Endstufe mit am Brückenzweig liegender induktiver Last und einem zugehörigen Paar von Brücken-Transistoren (letztere in Form von Ersatzschaltbildern jeweils mit zusätzlicher Darstellung von Freilaufdioden und parasitären Kapazitäten) zur Erläuterung bestimmter Schaltvorgänge bei positiver Strompolarität,
- Fig. 5a-5d: Darstellungen analog zu Fig. 4a bis 4d für Schaltvorgänge bei negativer Strompolarität und
- Fig. 6: weitere Signal-Diagramme zur Erläuterung der Vorgänge gemäß Fig. 4 und 5 zur Stromnulldurchgangserfassung.

In den verschiedenen Figuren der Zeichnung sind gleiche Teile, Komponenten, Signale und sonstige (elektrische) Größen stets mit den gleichen Bezeichnungen (Bezugszeichen) versehen.

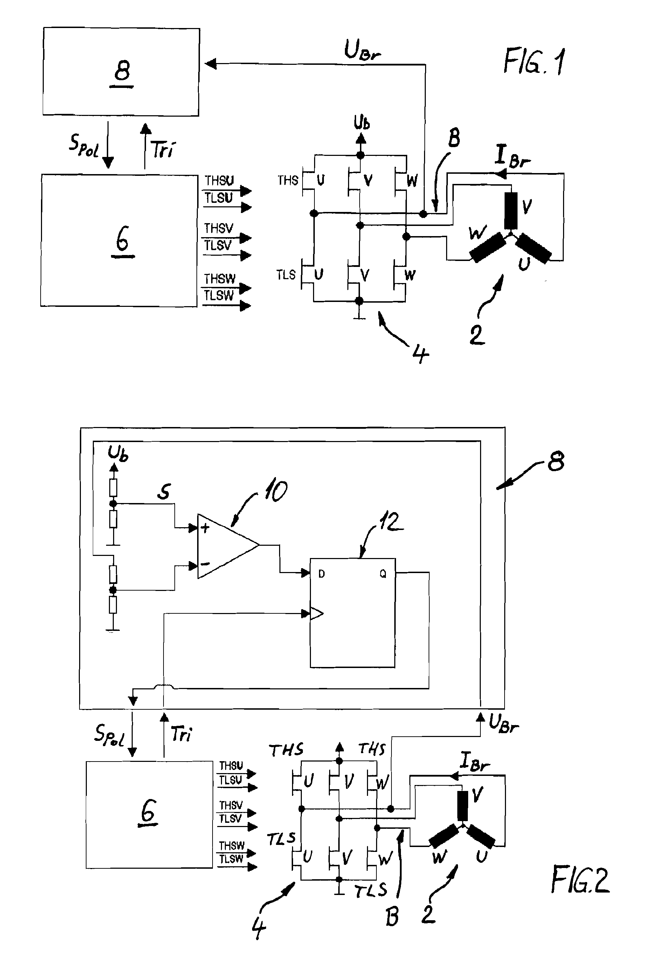

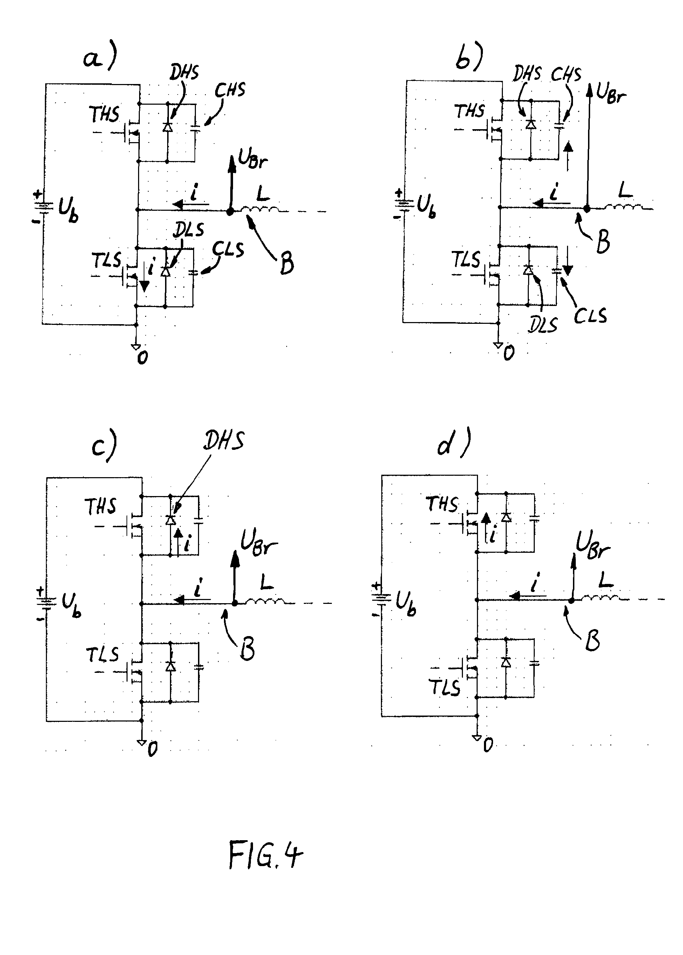

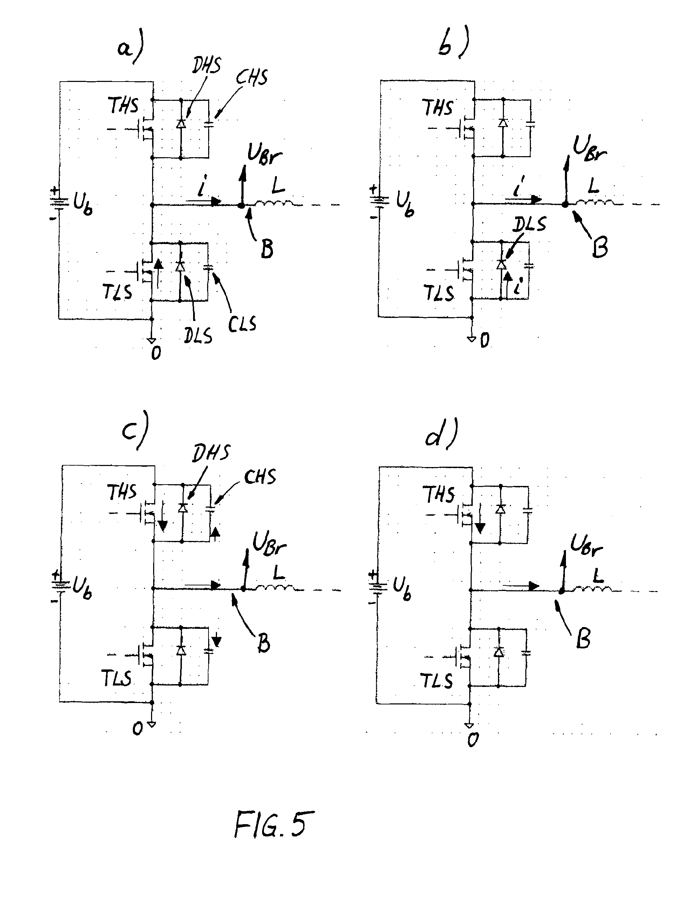

Die Fig. 1 und 2 zeigen für die bevorzugte, aber nur beispielhaft zu verstehende Anwendung jeweils schematisch in Sternschaltung drei Wicklungsstränge U, V, W eines Elektromotors 2 mit einer Brücken-Endstufe 4, die für den dreiphasigen Motor 2 als ebenfalls dreiphasige H-Brücke aus sechs Transistoren aufgebaut ist. Jedem Wicklungsstrang U, V, W bzw. jedem Brückenzweig B ist ein Paar von zwei Transistoren THS und TLS zugeordnet (THS = High-Side-Transistor; TLS = Low-Side-Transistor). Die Brücken-Transistoren werden von einer Steuereinheit 6 gesteuert und dazu mit Ansteuersignalen THSU, TLSU; THSV, TLSV; THSW, TLSW versorgt, wobei die Endstufe 4 an einer Versorgungsgleichspannung U_{b} von beispielsweise 24 Volt liegt (vgl. hierzu Fig. 4 und 5). Bevorzugt ist die Endstufe 4 aus MOSFETs oder aus IGBTs aufgebaut und wird so angesteuert, dass sie pulsweitenmodulierte Spannungen an die Wicklungsstränge des Motors 2 anlegt, wodurch sich jeweils ein Stromfluss durch die Wicklungen U, V, W einstellt. In Fig. 1 und 2 ist beispielhaft nur ein Brückenstrom I_{Br} für die Wicklung U eingezeichnet. Zur Auswertung der Wicklungsströme wird eine am Brückenzweig B abgegriffene Brückenspannung U_{Br} einer Auswerteeinheit 8 zur Ermittlung der Stromrichtung (Strompolarität) und des Stromnulldurchgangs (Polaritätswechsel) zugeführt. Die Auswerteeinheit 8 erhält von der Steuereinheit 6 zur Synchronisation ein Triggersignal Tri und erzeugt durch die Auswertung der Brückenspannung U_{Br} ein Strompolaritätssignal (Polsignal) S_{Pol}, welches die jeweilige Polarität (Richtung) des Brücken- bzw. Motorstroms I_{Br} wiedergibt. Ein erfasster Wechsel der Polarität repräsentiert einen Nulldurchgang, der ein Maß für die Phasenlage des Stroms ist.

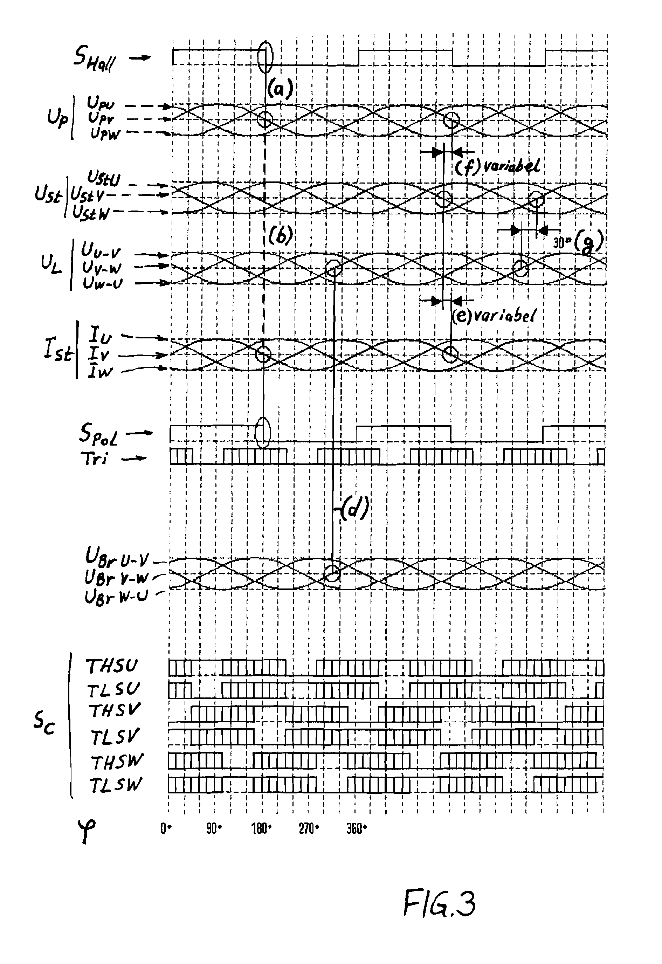

Die Diagramme in Fig. 3 veranschaulichen die Zusammenhänge bei der bevorzugten Anwendung einer Motor-Steuerung. Dabei gelten folgende Zusammenhänge:
- Die so genannten Polradspannungen U_{P} und ein die Rotorstellung repräsentierendes Hallsignal S_{Hall} haben einen festen Phasenbezug (s. Detail (a)).
- Strangspannungen U_{St} und Leiterspannungen U_{L} haben ebenfalls einen festen Phasenbezug (Detail (g)).
- Leiterspannungen U_{L} und mittlere Ausgangsspannungen U_{Br} der 3-Phasen-H-Brücke sind identisch (Detail (d)).
- Die Brückenausgangsspannungen sind die Folge der Brückenansteuersignale S_{C} und haben zu letzteren einen festen Phasenbezug.
- Zwischen den Polradspannungen U_{P} sowie den Strangströmen I_{St} und den übrigen Signalen (Strangspannungen, Leiterspannungen, Brückenausgangsspannungen, Brückenansteuersignale) bestehen keine festen Phasenbezüge, vielmehr variieren diese last- und drehzahlabhängig (s. Details (f) und (g)).

Ziel der Motorsteuerung ist es, den sich einstellenden Motorstrom I_{St} (beispielsweise I_{U} für die Wicklung U) durch Verschieben der Phasenlage der Ansteuersignale S_{C} (THSU, TLSU, THSV, TLSV, THSW, TLSW) in Phase zur Polradspannung U_{P} (beispielsweise für die Wicklung U zur Polradspannung U_{PU}) zu regeln (s. Fig. 3, Detail (b)). In diesem Zustand ist der Wirkungsgrad des Motors maximal. Zur Durchführung dieser Regelung werden einerseits ein Signal zur Bestimmung der Phasenlage der Polradspannung U_{P} und andererseits ein Signal zur Bestimmung der Phasenlage des Motorstroms I_{St} benötigt. Da die Polradspannungen einen festen Phasenbezug zu den Hallsignalen S_{Hall} haben, dient das Hallsignal zur Erkennung der Phasenlage der Polradspannung. Die Phasenlage des Motorstroms wird durch das Ausgangssignal (Polsignal S_{Pol}) der hier beschriebenen, erfindungsgemäßen Auswerteeinheit 8 bestimmt. Damit sind dann beide erforderlichen Größen für die Regelung der Phasengleichheit von Polradspannung und Motorstrom gegeben, so dass in der Steuereinheit 6 die Steuersignale S_{C} so generiert werden können, dass eine Phasenverschiebung zwischen Motorstrom und Motorspannung gegen Null geregelt werden kann.

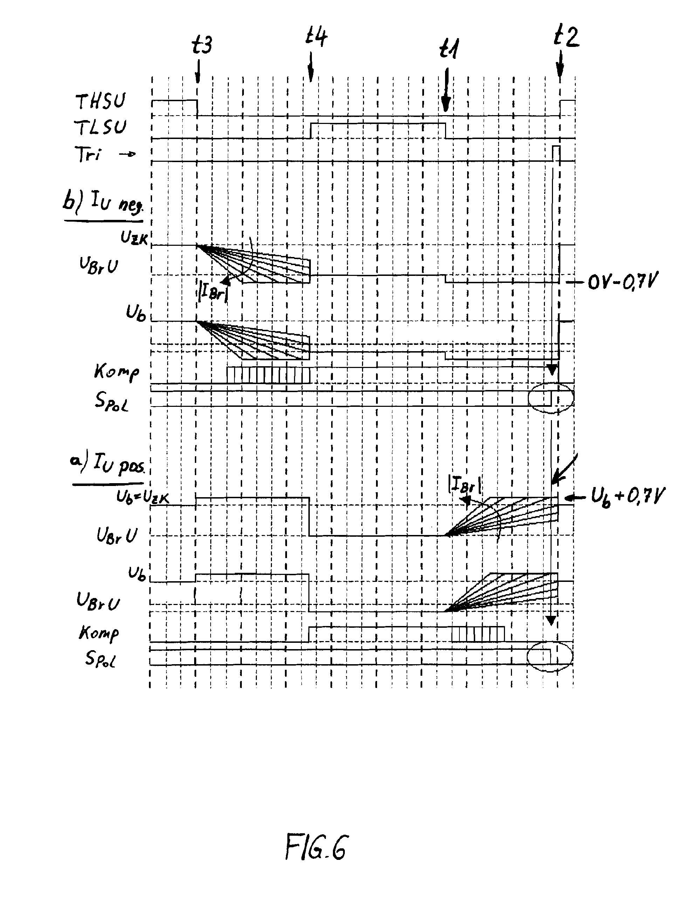

In den Fig. 4 und 5 ist jeweils ein typischer Ausschnitt der Brücken-Endstufe 4 dargestellt, wie sie für eine - zumindest zeitweise, d. h. zumindest im Bereich um einen zu erwartenden bzw. zu erfassenden Stromnulldurchgang - getaktete und vorzugsweise pulsweitenmodulierte Ansteuerung einer induktiven Last L (z. B. einer Motorwicklung) verwendet wird. Die Last L ist im Brückenzweig B zwischen den zugehörigen Transistoren THS und TLS angeschlossen. Die Transistoren sind beispielhaft als MOSFET ausgeführt, die folgenden Erläuterungen gelten aber uneingeschränkt auch für IGBTs. Bei der Last L kann es sich z. B. um einen der Wicklungsstränge U, V, W des Elektromotors 2 handeln, beispielsweise um die Wicklung U (vgl. die zugehörigen Signale in den Diagrammen in Fig. 6).

In den Figuren sind im MOSFET bauartbedingt enthaltene Freilaufdioden DHS, DLS sowie parasitäre Drain-Source-Kapazitäten CHS, CLS explizit als Ersatzschaltbild eingezeichnet, weil diese für die erfindungsgemäße Strompolaritätserfassung von Bedeutung sind.

Für die weiteren Betrachtungen soll beispielhaft die Stromrichtung durch den dargestellten Low-Side-Transistor TLS erfasst werden. Es sei dabei vorausgesetzt, dass ein Strom in TLS von Drain nach Source positive Polarität hat, negative Polarität sei entgegengesetzt. Weiterhin erfolgt die Polaritätserfassung bei dem beschriebenen Beispiel durch Auswertung der Schaltflanke beim Abschalten des Low-Side-Transistors TLS. Prinzipiell kann aber auch die Schaltflanke beim Einschalten ausgewertet werden.

In Fig. 4 sind die Vorgänge beim Abschalten von TLS im Falle positiver Strompolarität veranschaulicht. Fig. 4a zeigt den Zustand, in dem TLS noch eingeschaltet ist, während THS ausgeschaltet ist. Die Pfeile kennzeichnen die positive Stromrichtung (positive Polarität). Der Strom i fließt dabei über die Drain-Source-Strecke des leitenden TLS.

Wird dann gemäß Fig. 4b TLS abgeschaltet (Totzeit der beiden Transistoren TLS und THS), fließt der Strom i zunächst anteilig über dessen Drain-Source-Kapazität CLS sowie anteilig über die Drain-Source-Kapazität CHS des Transistors THS weiter und lädt dabei diese Kapazitäten um. Als Resultat steigt die am Brückenzweig B abgegriffene Brückenspannung U_{Br} allmählich von 0 V auf U_{b} +0,7 V an, d. h. die Versorgungsspannung der Brücke wird um die Flussspannung U_{DHS} der Freilaufdiode DHS erhöht. Zu diesem Vorgang wird auf Fig. 6, Zeitpunkt t1 verwiesen.

In Fig. 4c ist der Zustand während der Totzeit veranschaulicht, in der beide Transistoren TLS und THS ausgeschaltet sind, und bei positiver Strompolarität ist der Anstieg der Brückenspannung beendet (Freilauf). Sind die Drain-Source-Kapazitäten soweit umgeladen, dass die Brückenspannung um die Flussspannung der High-Side-Freilaufdiode DHS höher ist als die Versorgungsspannung U_{b}, wird die "obere" Freilaufdiode DHS leitend und übernimmt den Strom i.

Wird nun gemäß Fig. 4d der High-Side-Transistor THS eingeschaltet, übernimmt dessen Drain-Source-Strecke rückwärts leitend den Strom i. Die Totzeit der Ansteuerung ist beendet, s. den Zeitpunkt t2 in Fig. 6.

Aus diesen Erläuterungen wird deutlich, dass im Falle eines Schaltvorgangs bei positiver Strompolarität die Brückenspannung U_{Br} unmittelbar nach dem Abschalten von TLS mit einer durch das Umladen der Drain-Source-Kapazitäten CLS, CHS und von der Höhe des Stromes bestimmten Steigung ansteigt. Dieser Anstieg der Schaltflanke wird erfindungsgemäß als Kriterium für positive Strompolarität ausgewertet.

In Fig. 5 sind die Vorgänge beim Abschalten von TLS im Falle einer negativen Strompolarität veranschaulicht. Analog zu Fig. 4a zeigt die Fig. 5a den Zustand unmittelbar vor dem Schaltvorgang, wobei TLS noch eingeschaltet und THS ausgeschaltet sind. Der Strom i fließt somit rückwärts über die Drain-Source-Strecke von TLS.

Wird dann gemäß Fig. 5b TLS abgeschaltet (Beginn der Totzeit im Zeitpunkt t1 in Fig. 6), übernimmt dessen Freilaufdiode DLS den Strom i. Dabei fällt die Brückenspannung U_{Br} von 0 V auf etwa -0,7 V (Flussspannung von DLS).

Wird dann gemäß Fig. 5c THS eingeschaltet, steigt dessen Drain-Source-Strom an, bis der von der Freilaufdiode DLS geführte Strom vollständig übernommen wird. Anschließend werden die Drain-Source-Kapazitäten umgeladen, und die Brückenspannung steigt von -0,7 V auf U_{b} an (Zeitpunkt t2 in Fig. 6).

Ist gemäß Fig. 5d das Umladen der Drain-Source-Kapazitäten beendet, wird der Strom i nur noch von der Drain-Source-Strecke von THS geführt. Der Schaltvorgang ist beendet.

Somit ist festzustellen, dass bei einem Schaltvorgang im Falle negativer Strompolarität die abgegriffene Brückenspannung U_{Br} erst nach dem Einschalten von THS ansteigt. Sie bleibt dann während der gesamten Schalt-Totzeit zwischen Ausschalten von TLS und Einschalten von THS auf 0 V bzw. -0,7 V. Dies wird erfindungsgemäß als Kriterium für negative Polarität gewertet.

Wie sich nun aus Fig. 2 ergibt, enthält die Auswerteeinheit 8 zur Auswertung der abgegriffenen Brückenspannung U_{Br} einen Komparator 10, der die Brückenspannung U_{Br} mit einem vorgegebenen Schwellwert S vergleicht. Der Schwellwert S kann als Teilspannung an einem an der Versorgungsspannung U_{b} liegenden Spannungsteiler abgegriffen werden. Ebenso kann auch die abgegriffene Brückenspannung U_{Br} über einen Spannungsteiler geführt und reduziert werden. Der Ausgang des Komparators 10 ist mit einem nachgeschalteten Speicher 12 verbunden, der als Flip-Flop ausgeführt sein kann. Mit dem Komparator 10 kann zu jedem Zeitpunkt während der Schalt-Totzeit des Brückenzweigs geprüft werden, ob die - gegebenenfalls durch einen Spannungsteiler geteilte - Brückenspannung den Schwellwert überschritten hat oder nicht überschritten hat. Mit dem Triggersignal Tri kann diese Information zu jedem Zeitpunkt während der Schalt-Totzeit in den nachgeschalteten Speicher 12 übernommen werden, wo diese Information bis zum nächsten Triggern erhalten bleibt. Somit kann geprüft werden, ob die Schaltflanke der Brückenspannung U_{Br} nach dem Anschalten von TLS und vor dem Einschalten von THS ansteigt, was dann ein Kriterium für die positive Strompolarität ist, oder ob die Brückenspannung U_{Br} erst nach dem Einschalten von THS ansteigt. Letzteres wäre eine eindeutige Information für die negative Strompolarität. Damit liegt in jedem Fall eine eindeutige Information über die Polarität des Brückenstroms vor. Diese Information wird als Polsignal S_{Pol} von der Auswerteeinheit 8 an die Steuereinheit 6 geleitet.

Vorteilhafterweise liegt der Zeitpunkt der Abtastung (Trigger) nahe vor dem Einschalten von THS, im Extremfall genau im Einschaltzeitpunkt. So können auch kleine Ströme noch ausreichend genau hinsichtlich ihrer Polarität ausgewertet werden, da ausreichend Zeit zum Umladen der Ausgangskapazitäten zur Verfügung steht. Je weiter der Auswertezeitpunkt zeitlich nach hinten (später) geschoben wird, desto kleinere Ströme führen noch zu einer auswertbaren Spannung über den Ausgangskapazitäten. Die Steigung des Anstiegs der Brückenspannung U_{Br} nimmt mit zunehmendem Brückenstrom zu. Dies wird in Fig. 6 durch mehrere unterschiedlich steile Flanken veranschaulicht.

Die Erfindung ist nicht auf das beschriebene Ausführungsbeispiel beschränkt. Der Vergleich mit einem Schwellwert durch einen Komparator kann im Einzelfall variieren. Beispielsweise kann bei hohen Brückenspannungen und kleinen Strömen der untere Widerstand des Brückenspannungsteilers entfallen und stattdessen das Komparator-Eingangssignal aktiv auf die Versorgungsspannung U_{b} begrenzt werden, um damit den Innenwiderstand der Teilerschaltung zu erhöhen und so die Grenze der auswertbaren Ströme zu kleineren Strömen hin zu verschieben (Erhöhung der Empfindlichkeit der Auswerteeinheit). Auch ist ein Ersatz des unteren Spannungsteilerwiderstands durch eine Zenerdiode oder ähnliche nicht lineare Begrenzungen anwendbar, was ebenfalls die Empfindlichkeit der Auswertung erhöht. Bei Verwendung der natürlichen Schaltschwelle des Eingangs eines Logikgatters können der Komparator und der Teiler für das Einstellen der Schaltschwelle ersetzt werden.

Weiterhin ergeben sich bei alternativer Auswertung der Schaltflanke zwischen Abschalten von THS und Einschalten von TLS sinngemäß gleichartige Zusammenhänge, die in Fig. 6 zusätzlich veranschaulicht sind (Zeitpunkte t3, t4). Die beschriebene Ausführung wird aber bevorzugt, weil eine Auswertung nahe Masse einfacher ist als nahe U_{b}.

Durch die Erfindung werden wichtige Vorteile erreicht:
- einfache digitale Auswertung mit nur einem Komparator und wenigen sonstigen Bauteilen
- kein Messwiderstand (Shunt, On-Widerstand) erforderlich; dadurch können Endstufenverluste minimiert und Bauteile (Messwiderstand) eingespart werden
- Einsatz bei Netzspannungsanwendungen und optimal bei kleinen Spannungen möglich, bei denen kaum auswertbare Spannungsabfälle über den dabei typischerweise sehr kleinen Bahn-Widerständen der dabei typischerweise verwendeten MOSFETs vorhanden sind
- keine analoge Filterung, Verstärkung und Messung kleiner Spannungsabfälle über Messwiderstände notwendig, gerade bei kleinen Strömen direkt um den Nulldurchgang wird das auswertbare Nutzsignal immer kleiner und geht gegen Null (Störanfälligkeit, Toleranzprobleme, Offset-Probleme usw.)
- Die erfindungsgemäßen Maßnahmen liefern auch bei kleinen Strömen ein hinreichend eindeutiges Signal; damit ist das System weniger störanfällig
- reduzierte Anfälligkeit gegenüber Bauteil-Toleranzen

Die Erfindung ist nicht auf die dargestellten und beschriebenen Ausführungsbeispiele beschränkt, sondern umfasst auch alle im Sinne der Erfindung gleichwirkenden Ausführungen. Ferner ist die Erfindung bislang auch noch nicht auf die im jeweiligen unabhängigen Anspruch definierte Merkmalskombination beschränkt, sondern kann auch durch jede beliebige andere Kombination von bestimmten Merkmalen aller insgesamt offenbarten Einzelmerkmalen definiert sein. Dies bedeutet, dass grundsätzlich praktisch jedes Einzelmerkmal des jeweiligen unabhängigen Anspruchs weggelassen bzw. durch mindestens ein an anderer Stelle der Anmeldung offenbartes Einzelmerkmal ersetzt werden kann. Insofern sind die Ansprüche lediglich als ein erster Formulierungsversuch für eine Erfindung zu verstehen.

## Patentansprüche

1. Verfahren zum Erfassen einer Strompolarität eines durch eine induktive Last (U, V, W; L) fließenden Stromes (I_{Br}), wobei die Last (U, V, W; L) an einem Brückenzweig (B) einer aus Transistoren (THS, TLS) bestehenden Brücken-Endstufe (4) liegt und die Endstufe (4) über eine Steuereinheit (6) zumindest zeitweise getaktet angesteuert wird,
**dadurch gekennzeichnet, dass** die Strompolarität indirekt durch eine Auswertung des zeitlichen Verlaufs von Schaltflanke einer am Brückenzweig (B) abgegriffenen Brückenspannung (U_{Br}) während einer Totzeit im ausgeschalteten Zustand der dem Brückenzweig (B) zugeordneten Transistoren (THS, TLS) bestimmt wird.

2. Verfahren nach Anspruch 1,
**dadurch gekennzeichnet, dass** die Endstufe (4) über die Steuereinheit (6) zur Erzeugung einer sinusmodulierten Spannung getaktet und pulsweitenmoduliert angesteuert wird.

3. Verfahren nach Anspruch 1 oder 2,
**dadurch gekennzeichnet, dass** die Brückenspannung (U_{Br}) zur Auswertung ihres Verlaufs mit einem vorgegebenen Schwellwert (S) verglichen wird, wobei anhand des Vergleichsergebnisses ein Strompolaritätssignal (S_{Pol}) für die Steuereinheit (6) erzeugt wird.

4. Verfahren nach einem der Ansprüche 1 bis 3,
**gekennzeichnet durch** eine Anwendung zum Steuern eines insbesondere dreiphasigen Elektromotors (2).

5. Einrichtung zur Durchführung des Verfahrens nach einem der vorhergehenden Ansprüche,
**gekennzeichnet durch** eine Auswerteeinheit (8) für eine am Brückenzweig (B) abgegriffene Brückenspannung (U_{Br}) auf ihren zeitlichen Verlauf während einer Totzeit im ausgeschalteten Zustand der dem Brückenzweig (B) zugeordneten Transistoren (THS, TLS).

6. Einrichtung nach Anspruch 5,
**dadurch gekennzeichnet, dass** die Auswerteeinheit (8) einen Komparator (10) zum Vergleichen der Brückenspannung (U_{Br}) mit einem vorgegebenen Schwellwert (S) aufweist, wobei ein Ausgang des Komparators (10) mit einem Speicher (12) verbunden ist, der in Abhängigkeit von der indirekt anhand des Verlaufs der Brückenspannung (U_{Br}) erfassten Stromrichtung ein von der Steuereinheit (6) getriggertes Strompolaritätssignal (S_{Pol}) für die Steuereinheit (6) erzeugt.

7. Einrichtung nach Anspruch 5 oder 6,
**dadurch gekennzeichnet, dass** die Transistoren (THS, TLS) der Brücken-Endstufe (4) von MOSFETs oder IGBTs gebildet sind, die jeweils eine Freilaufdiode (DHS, DLS) und eine parasitäre Kapazität (CHS, CLS) parallel zu ihrer Schaltstrecke (Drain-Source) aufweisen.

8. Einrichtung nach einem der Ansprüche 5 bis 7,
**dadurch gekennzeichnet, dass** dieEndstufe(4)alsdreiphasige H-Brücke mit sechs Transistoren (THSU, TLSU; THSV, TLSV; THSW, TLSW) ausgebildet ist, die paarweise jeweils einer von einer Wicklung (U, V, W) eines dreiphasigen Elektromotors (2) gebildeten Last zugeordnet sind.
